Europäisches Patentamt

European Patent Office

Office européen des brevets

(11) Publication number: **0 200 513**
A1

(12) # EUROPEAN PATENT APPLICATION

(21) Application number: 86303190.2

(22) Date of filing: 28.04.86

(51) Int. Cl.⁴: **H 05 K 9/00**

(30) Priority: 29.04.85 IE 1076/85

(43) Date of publication of application:
05.11.86 Bulletin 86/45

(84) Designated Contracting States:
AT BE CH DE FR GB IT LI LU NL SE

(71) Applicant: Prendergast, Patrick Thomas
Baybush
Straffan Kildare(IE)

(71) Applicant: Prendergast, Mary Josephine
Baybush
Straffan Kildare(IE)

(71) Applicant: Prendergast, Patrick Edward
Baybush
Straffan Kildare(IE)

(71) Applicant: Shanahan-Prendergast, Elizabeth
Baybush
Straffan Kildare(IE)

(71) Applicant: Prendergast, Leo Joseph
Baybush
Straffan Kildare(IE)

(72) Inventor: Prendergast, Patrick Thomas
Baybush
Straffan Kildare(IE)

(74) Representative: Thiemann, Peter Albert William et al,
LLOYD WISE, TREGEAR & CO. Norman House 105-109
Strand
London WC2R 0AE(GB)

(54) A shield for electronic apparatus.

(57) A shield (1) for electronic apparatus (2) such as a visual display unit (2) to prevent or reduce emission of radiated signals, such as radio waves, comprises a base (8) to support the visual display unit (2) and a cover (9) extending over the unit (2) and in secure electrical engagement with the base (8). The base (8) is of sheet metal, and the cover (9) is formed from a single sheet of nickel coated woven polyester textile material stitched together. The cover (9) and base (8) are secured by metallised hooks and loops fasteners (36,37). A transparent electrically conductive screen (44) provides visual access to the visual display unit (2).

Fig. 3

EP 0 200 513 A1

Croydon Printing Company Ltd.

Title:  A SHIELD FOR ELECTRONIC APPARATUS

The present invention relates to a shield for electronic apparatus to prevent, reduce or distort the emission of radiated signals, for example electro-magnetic signals, radio waves, ultra high frequency waves, very high frequency waves, micro waves or the like, the shield being of the type which in use is adapted to extend at least partly around the apparatus.

- 2 -

It has been known for some time that certain units of
data processing hardware, such as for example, a visual
display unit, keyboard and their connecting cables and
the like, during operation emit radio frequency signals,
particularly in commonly used television broadcast bands
one and three.  These signals are modulated and are in
the form of harmonics and carry a signal with the same
information content as the signal being processed.  In
the case of visual display units, an extended pulse
chain is emitted equivalent to the information being
displayed on the screen of the visual display unit.

Needless to say, these broadcasts are unintentional and
are incidental to the normal operation of the data processing apparatus. However, it has been found that readily available equipment may be used to remotely receive and amplify these signals. The signals can then be displayed on a visual display unit. It has been found that these signals may be picked up at distances of the order of 1,000 metres from their source. This presents considerable problems with confidential data. In fact, as a result of this, secrecy of records in banks, insurance companies, hospitals, solicitors offices, accounts departments, personnel departments, research establishments, defence systems, government services etc. can no longer be guaranteed.

Some efforts have been made to provide shields for shielding such equipment to prevent the emission of radio frequency waves, however, in general these have tended to be unsatisfactory. In most cases, they are either too expensive or not sufficiently versatile for use in the average office or the like. For example, it is known to mount heavy lead or other metal shields around the electronic circuitry within the housing of the apparatus and while this does undoubtedly reduce the emission of radio frequency waves these devices are totally unsuitable for the ordinary office where it is necessary to be able to easily move a piece of data processing equipment from one location to another. Needless to say, where lead shields are used, the resulting piece of equipment tends to be relatively heavy and bulky.

Another alternative is to mount the entire apparatus in a heavy metal casing. Again, this has the problem that the resultant piece of apparatus is relatively heavy and also cumbersome, and thus cannot be moved from place to place within an office easily.

For example, U.S. Patent specification No. 4381421 discloses a shielding arrangement for a cathode ray tube. In this case a heavy metal enclosure is described surrounding the tube and a transparent shield comprising a thin metal mesh laminated between two panels of glass provides visual access to the screen. This device, while undoubtedly it would reduce the emission of radio waves, is unsuitable in most cases, since it would lead to a relatively heavy and cumbersome unit. U.S Patent specification No. 4514585 also discloses a shield for reducing emission of radio waves from a cathode ray tube. In this case also the shield comprises a heavy metal enclosure and a transparent shield to permit visual access to the cathode ray screen. This shield suffers from the same problems as that of U.S. Patent specification No. 4381421.

There is thus a need for a shield for electronic data processing hardware units which overcomes the problems associated with known shields. Indeed, there is also a need for such a shield for other electronic apparatus.

The present invention is directed to providing a shield for electronic apparatus which overcomes the problems of shields known heretofore.

The invention overcomes the problems of known shields in that the shield is removably mountable on the apparatus and is of a material which prevents, reduces or distorts the signals.

The advantages of the invention are many.  However, one of the important advantages is that the shield according to the invention is relatively lightweight and can be readily easily mounted and removed from the apparatus to be shielded.

Preferably, at least portion of the shield is of a flexible material.  Advantageously, the flexible material is a metallised textile material.

The advantage of these features of the invention is that by virtue of the fact that the shield is of a flexible material, it can readily easily be mounted on the apparatus to be shielded.  Furthermore, the material is of a relatively lightweight and thus the shield is of a lightweight nature and does not interfere with the ability of the apparatus being shielded to be easily moved from place to place.

In one embodiment of the invention, the flexible material is a woven multifilament polyester coated with nickel and having a nominal DC resistivity of 0.12  ohms/ sq cm,   screen attenuations for far field conditions of

0200513

60 dB at 10 MHz and 70dB at 26 GHz, and a tolerated power density at 12 GHz with 10 minutes continuous exposure of $3W/cm^2$.

The advantage of this feature of the invention is that the shield is of considerable lightweight and also in most cases prevents and in virtually all cases reduces the level of radiated signals to a level which prevents them being remotely picked up.

In another embodiment of the invention the shield extends completely around the apparatus, an opening being provided for entry of the apparatus into the shield, and a closure member closing the opening, the closure member being secured to the shield by quick release fastening means, the closure member being in electrical conductive engagement with the shield around the periphery of the opening.

The advantage of this feature of the invention is that by virtue of the fact that the shield extends completely around the apparatus, it is particularly effective in preventing and reducing the emission of radio signals. Furthermore, by virtue of the fact that an opening closed by a closure member is provided, the shield can readily easily be mounted and removed from the apparatus.

In a further embodiment of the invention, the shield comprises a top cover of flexible material having a top member, front, rear and side members extending from the top member, the opening being defined by the lower portion of the front, rear and side members, and the closure member being provided by a base member of a rigid material and electrically conductive.

The advantage of this feature of the invention is that the shield can be readily easily mounted on or removed from the apparatus to be shielded.

Advantageously, portion of the cover adjacent the opening overlaps portion of the base.

The advantage of this feature of the invention is that it further assists in reducing and eliminating the level of signals radiated.

Preferably, the rear member is hingeable relative to the top member and is secured to the side members by quick release fastening means, the rear member being in electrically conductive engagement with the side members along the length of the joints.

The advantage of this feature of the invention is that the apparatus is particularly adaptable for quick mounting and releasing from the apparatus.

In another embodiment of the invention, at least portion of the shield is of a transparent or translucent material to provide visual contact with the apparatus. Preferably, the transparent or translucent material is formed by a panel of glass laminated with a grid of metal material, the laminated panel being mounted in a frame of electrically conductive material secured to and in electrically conductive engagement with the shield.

The advantage of this feature of the invention is that while permitting visual access to the apparatus being shielded, it also prevents or considerably reduces the emission of radio waves from the apparatus. In particular, it prevents or reduces the radiated waves from a screen of a visual display unit.

In a further embodiment of the invention an inlet and outlet vent are provided for the circulation of air through the shield, the vents being provided by a plurality of elongated holes, and a fan is provided to circulate air.

The advantage of this feature of the invention is that the vents permit the circulation of air through the shield and in turn through the apparatus, thereby avoiding overheating of either the apparatus or the shield, and where the vents are provided by a plurality of elongated holes, the holes tend to attenuate the signal which would otherwise be emitted through the vent. In fact, it has been found that where the holes are relatively long and narrow in cross section, considerable attenuation of the radio signal is achieved. In fact, by using holes of 20 millimetres long by 5 millimetres in diameter, it has been found that the attenuation is usually sufficient to avoid any unauthorised interception of the data.

Advantageously, a cable inlet is provided in the shield, the inlet being closed by a flexible seal, and preferably, the flexible seal is provided by a brush member comprising a plurality of metal coated fibres extending across the cable inlet.

The advantage of this feature of the invention is that it further secures the cable, and thus avoids the possibility of radiated waves escaping through the cable inlet.

In another embodiment of the invention, the quick release fastening means is provided by metal coated hook and loop fasteners.

The advantage of this feature of the invention is that the shield can readily easily be mounted on or removed from the apparatus. Furthermore, by virtue of the fact

0200513

that metallised hooks and loop fasteners are used, electrical continuity over the entire length of the joint is achieved, thereby preventing any possible escape of radio waves between any gaps which may otherwise form in a long joint.

The invention will be more clearly understood from the following description of some preferred embodiments thereof, given by way of example only with reference to the accompanying drawings, in which:

Fig. 1 is a perspective view of a shield according to the invention,

Fig. 2 is a rear perspective view of the shield of Fig. 1,

Fig. 3 is a partly exploded perspective view of the shield of Fig. 1,

Fig. 4 is a partly cut-away perspective view of the shield of Fig. 1,

Fig. 5 is a partly cut-away rear perspective view of the shield of Fig. 1,

Fig. 6 is a sectional side view of the shield of Fig. 1,

Fig. 7 is a front perspective view of portion of the shield of Fig. 1,

Fig. 8 is an underneath perspective view of portion of the shield of Fig. 1,

Fig. 9 is a perspective view of a detail of the shield of Fig. 1,

Fig. 10 is a perspective view of the detail of Fig. 9 in a different position,

Fig. 11 is a perspective view of another detail of the shield of Fig. 1,

Fig. 12 is a sectional side view of the detail of Fig. 11,

Fig. 13 is a sectional view of another detail of the shield of Fig. 1,

Fig. 14 is a sectional view of the detail of Fig. 13 in a different position,

Fig. 15 is a perspective view of a further detail of the shield of Fig. 1,

Fig. 16 is a sectional view of another detail of the shield of Fig. 1,

Fig. 17 is an end view of a further detail of the shield of Fig. 1,

Fig. 18 is a sectional view of a still further detail of the shield of Fig. 1,

Fig. 19 is a perspective view of portion of the shield of Fig. 1,

Fig. 20 is a perspective view of another portion of the shield of Fig. 1,

Fig. 21 is a side view of the portion of Fig. 20,

Fig. 22 is a perspective view of a shield according to another embodiment of the invention,

Fig. 23 is a partly exploded perspective view of the shield of Fig. 22,

Fig. 24 is an exploded view of the shield of Fig. 22,

Fig. 25 is a perspective view of a shield according to another embodiment of the invention,

Fig. 26 is a perspective view of a visual display unit to be shielded by the shield of Fig. 25,

Fig. 27 is a perspective view of portion of the shield of Fig. 25,

Fig. 28 is a perspective view of another portion of the shield of Fig. 25,

Fig. 29 is a perspective view of a still further portion of the shield of Fig. 25,

Fig. 30 is a sectional side view of the portion of Fig. 29, and

Fig. 31 is a side sectional view of the shield of Fig. 25 illustrating the visual display unit in place.

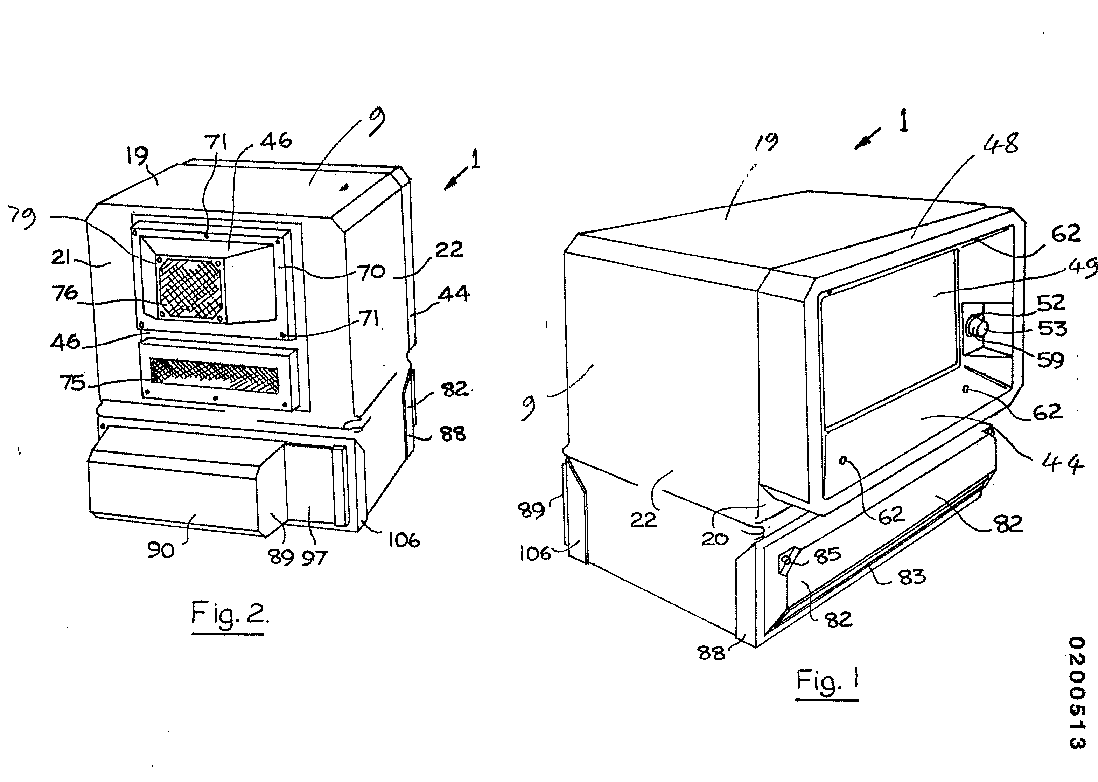

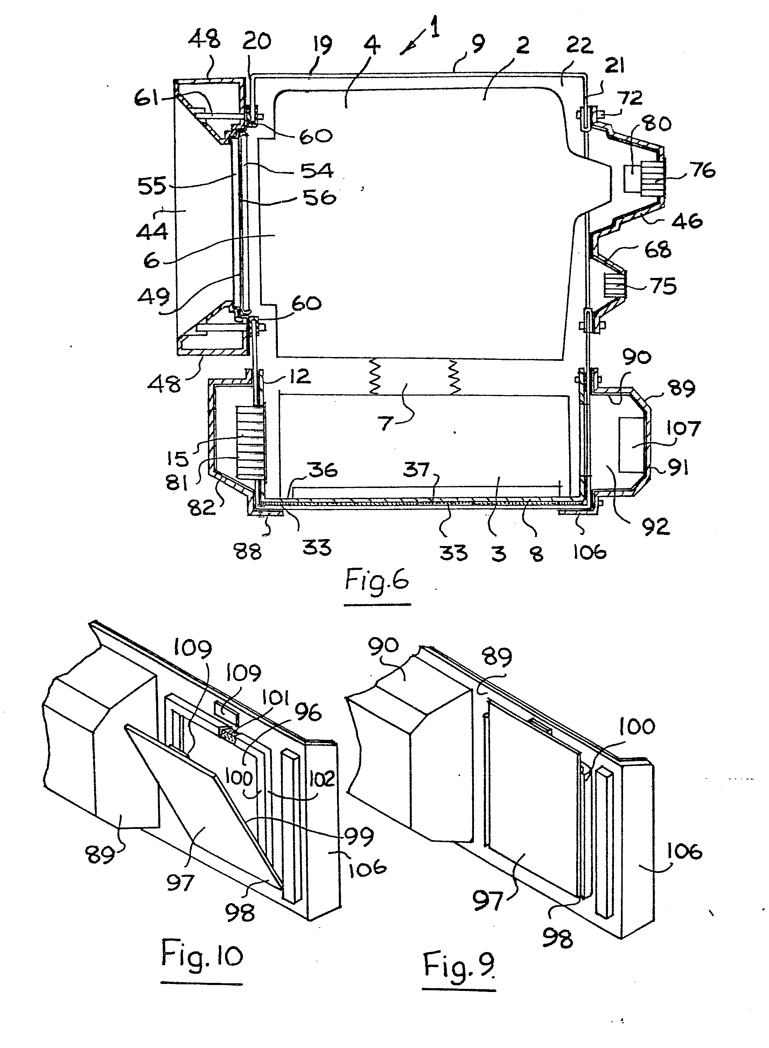

Referring to the drawings and initially to Figs. 1 to 21 there is illustrated a shield according to the invention, indicated generally by the reference numeral 1 for shielding electronic apparatus, in this case a visual display unit indicated by the reference numeral 2 (see Fig. 6) to reduce the emission of radiated signals, in this case, radio wave emission. The visual display unit 2 is a conventional device having a plinth 3 supporting a main housing 4 in which a visual display screen 6 is provided. A flexible mounting 7 is provided between the plinth 3 and the housing 4.

The shield 1 comprises a housing having a base 8 and a cover 9. The base 8 is of sheet metal folded at 10 to form a base portion 11 a front wall 12 and a rear wall 14. A vent 15, as will be described below, is provided in the front wall 12. An opening 16 to accommodate cable entry into the shield is provided in the rear wall 14, as will be described below.

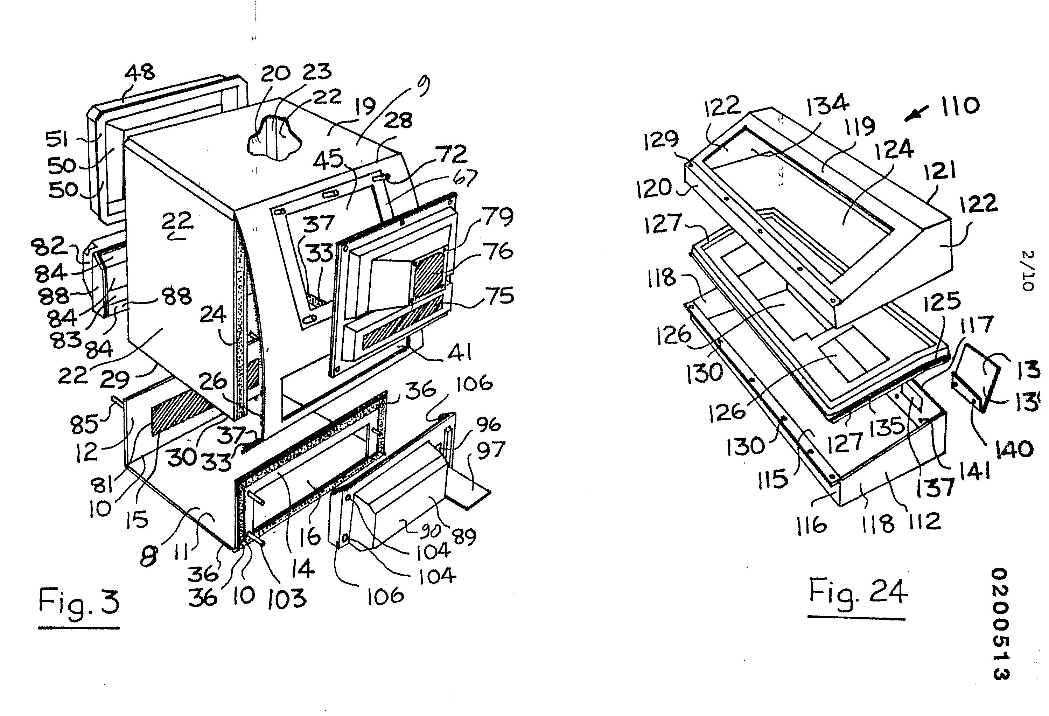

The cover 9 is of a flexible material in this case an electrically conductive metal coated polyester woven fabric sold by "Surrey Electro-Materials Limited" of Great Britain under type No. 51-PMU-100. The fabric has an open surface area approximately 1%, having a nominal DC resistivity of 0.12 ohms/sq cm, screen attenuations for far field conditions of 60dB at 10 MHz and 70dB at 26 GHz and a tolerated power density at 12 GHz with 10 minutes continuous exposure of 3W/cm². The cover 9 comprises a top member 19, a front member 20, a rear member 21 and side members 22. These are cut from a single sheet of the fabric and flaps 23 and 24 are provided on the side members 22 to form an overlap with the front and rear members 20 and 21 respectively. The front member is stitched to the side members 22 along the flaps 23, with tight secure stitching to ensure electrically conductive engagement between the front and side members along the flaps 23. The rear member 21 is hingeable along the line 28 (see Fig. 3) to the top member 19 and is releasably secured to the flaps 24 of the side member 22 by fastening means, in this case metallised hook and loop fasteners sold under the trade name VELCRO, see Fig. 3. Strips 25 of either hooks or loops are stitched in electrical conductive engagement to the flaps 24 of the side members 22, and corresponding strips 26 of the hook and loop fasteners is stitched with electrical conductive engagement to the rear member 21.

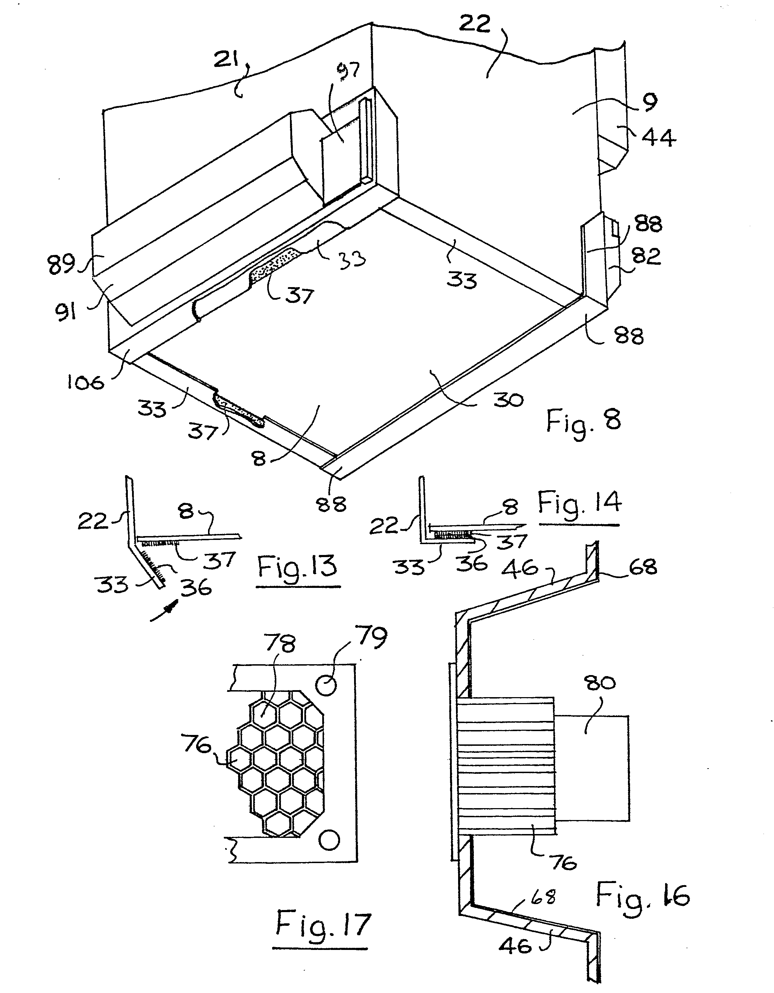

The lower ends 29 of the front, rear and side members 20, 21 and 22 form an opening 30 into the shield 1. The base 8 as can be seen acts as a closure member to close the opening 30. Flaps 33, see Figs. 3 and 8,are provided on the lower portion of the front, rear and side members 20 to 22, so that the cover 9 overlaps portion of the base 8. The cover 9 is secured to the base 8 by releasable fastening means, in this case, provided by metallised hook and loop fasteners similar to the hook and loop fasteners 25 and 26.  Strips 36 of either hooks or loops are provided on the base 8 to engage corresponding strips 37 of hooks or loops on the front and rear members 20 and 21 and on the flaps 33.  The strips 36 are secured to the base 8 by an electrically conductive adhesive, thus ensuring complete electrical conductive engagement between the base 8 and the cover 9.

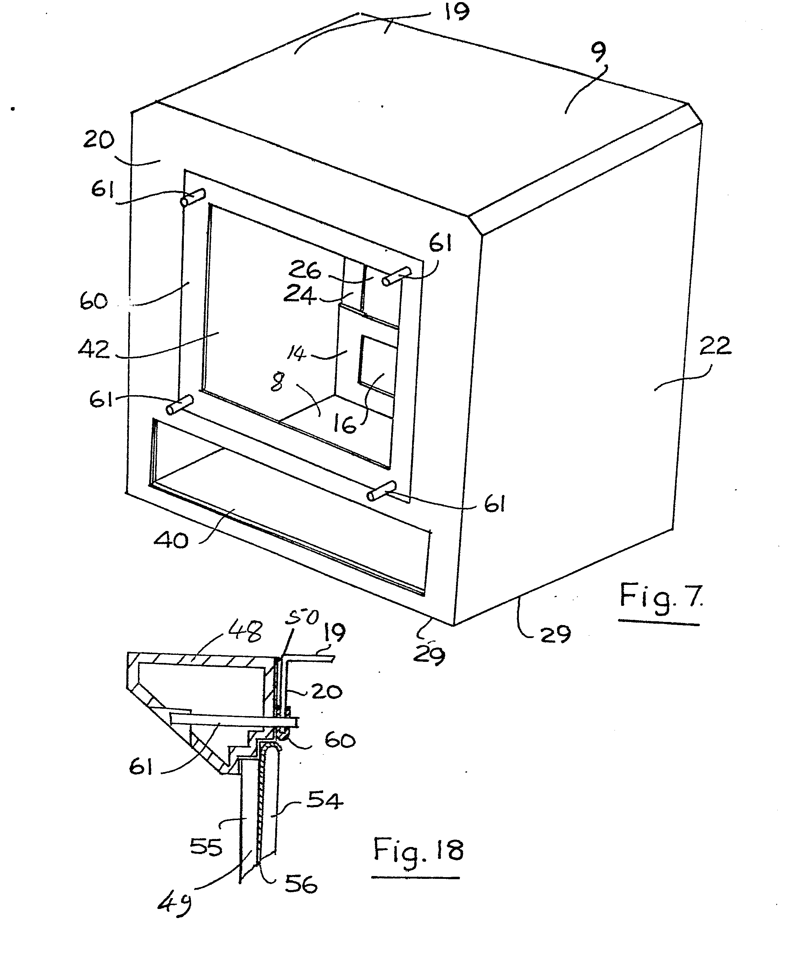

Openings 40 and 41 are provided respectively in the front and rear members 20 and 21 to correspond with the vent 15 and the opening 16 in the base 8, see Figs. 3 and 7.  An opening 42 is provided on the front member 20 to accommodate a transparent member 44 to provide visual contact with the screen, and an opening 45 is provided in the rear member 21 to accommodate a vent member 46.

The transparent member 44 comprises a frame 48 and a screen 49.  The frame 48 is vacuum formed from acrylonitride butadine styrene (ABS) material. An electrically conductive metal foil 50 is laminated to the inner surface of the frame 48.  The foil 50 extends out and over the peripheral flange 51 of the frame 48 to engage the shield 1 with electrically conductive engagement as will be described below.  The screen 49 comprises an inner and outer laminate 54 and 55 respectively of glass, and a central electrically conductive grid 56 between the laminates 54 and 55. The grid 56 is of silver and is applied to the laminate 55 by a metal spluttering technique in an argon gas filled chamber. As can be seen, the grid 56 extends over the edge and is lapped around the inner face 57 of the laminate 54. The outer laminate 55 is then bonded with a clear adhesive to the inner laminate 54. The screen 49 is secured in the frame 48 so that the exposed portion 58 of the grid 56 is in electrical conductive engagement with the foil 50 of the frame 48. Clips (not shown) secure the screen 49 in the frame 48. An opening 52 is provided in the frame 48 to permit a control of the visual display unit 2 to project therethrough. A hollow member 59 of electrical conductive metal with an end cap 53 is slidably engagable by means of a tight fit in the opening 52 to cover the control.

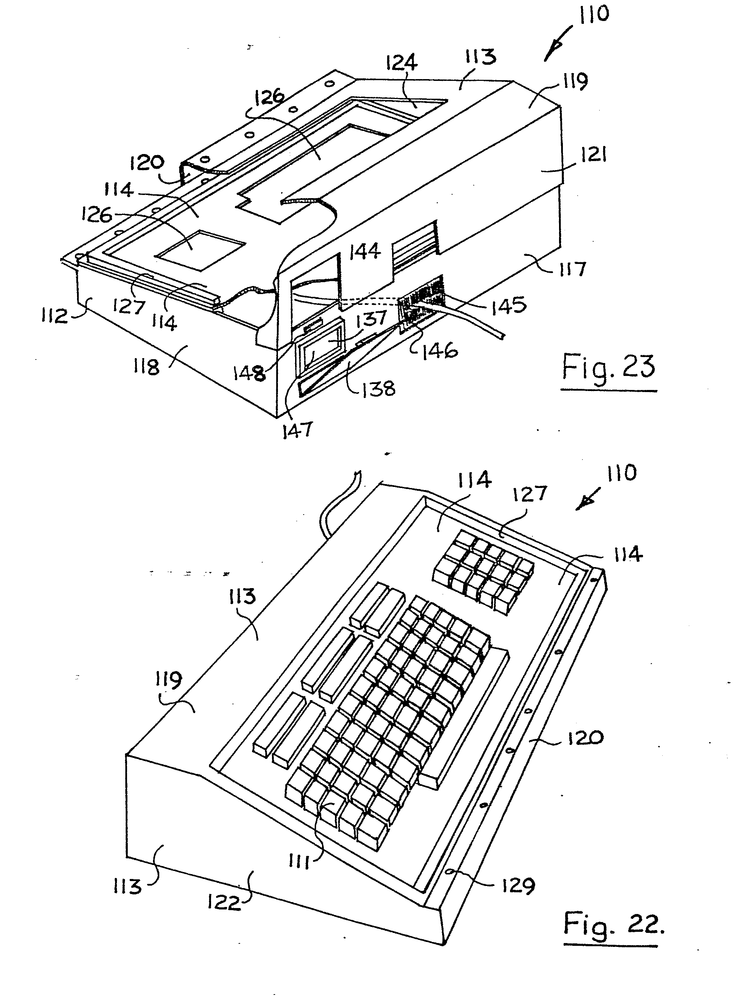

A folded metal sub-frame 60 extends around the opening 42 and is secured to the front member 20 by an electrically conductive adhesive. Screws 61 extending from the frame 60 engage corresponding holes 62 in the frame 48. Nuts (not shown) on the screws 61 secure the frame 48 to the front member 20. Thus, the peripheral flange 51 with the metal foil 50 tightly abuts the sub-frame 60 when the frame 48 is secured thereby giving electrical continuity between the front member 20, the frame 48 and in turn the screen 49, see Fig. 18.

A sub-frame 67 similar to the frame 60 extends around the opening 45 to secure the venting member 46 to the rear member 21. The venting member is of vacuum formed ABS similar to the frame 48. In this case, the inner surface of the vent member 46 is also laminated with an electrically conductive metal foil. A flange 70 extends around the periphery of the venting member 46 and the foil 68 extends over the flange 70. Holes 71 in the flange 70 engage screws 72 on the sub-frame 67 and nuts (not shown) secure the vent member 46 to the sub-frame 67, thus ensuring electrical conductive engagement between the vent member 46 and the rear member 21. An inlet vent 75 and an outlet vent 76 are provided in the vent member 46. Both vents 75 and 76 are of metal members having a plurality of elongated holes 78 arranged in honeycomb formation. The holes 78 are of sufficient length and of sufficiently small diameter to attenuate any radio emission through the vents 75 and 76 to prevent the emissions being picked up remotely and reproduced. In this particular case the holes are of 5 millimetres diameter and 20 millimetres long. As can be seen the foil 68 is arranged to tightly abut against the inlet and outlet vent 75 and 76 thereby ensuring electrical continuity between the vents 75 and 76 and the vent member 46. Screws 79 secure the vents 75 and 76 in the vent member 46. An air circulating fan 80 illustrated in block representation is mounted in the vent member 46 adjacent the outlet vent 76. The fan 80 is driven by an electrically powered motor (not shown).

The inlet vent 15 mounted in the front wall 12 of the base 8 is substantially similar to the inlet vent 75 and is formed of metal with a plurality of holes 81 in honeycomb formation. The length and diameter of the holes 81 is similar to the holes 78 of the vents 75 and 76.

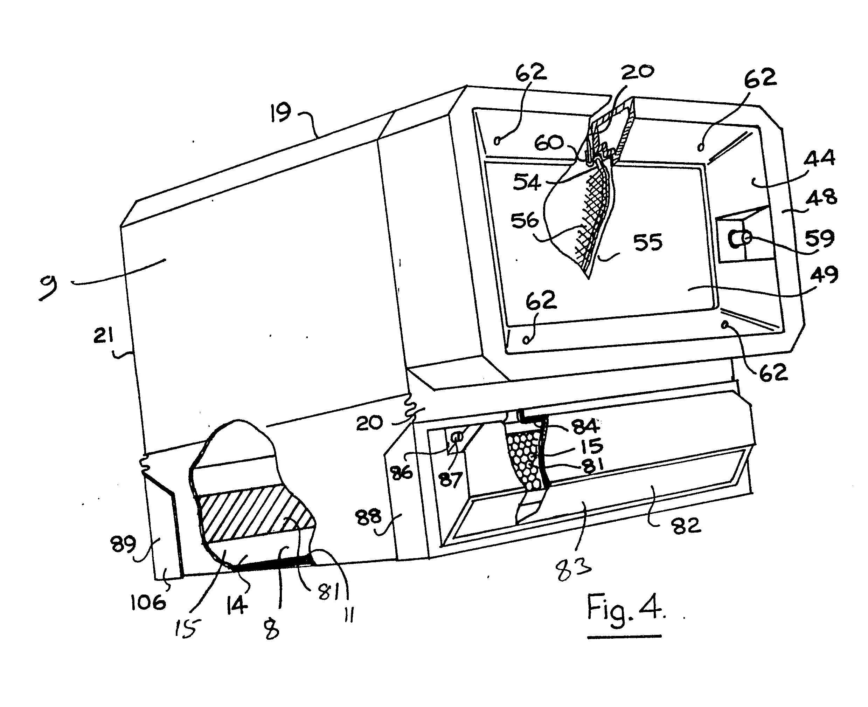

A cover member 82 of vacuum formed ABS plastics material is provided at the front of the shield 1 and secures the front member 20 of the cover 9 to the base 8. An opening 83 to communicate with the vent 15 is provided in the cover member 82. The inner surface of the member 82 is laminated with an electrically conductive metal foil 84. Screws 85 extending from the base 8 engage holes 86 in the member 82 and the member 82 is secured by nuts 87. As can be seen in Figs. 4 and 8, flanges 88 extend from the member 82 to provide protection for the corners of the cover 9 where they extend over the edges of the base 8.

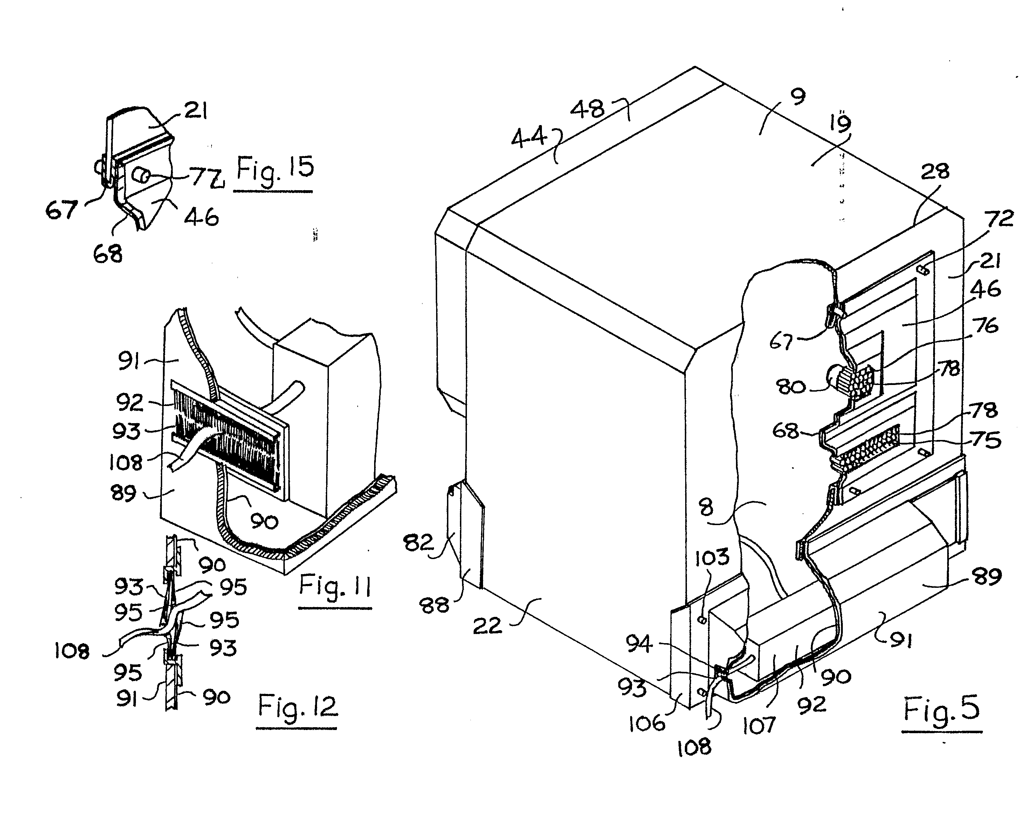

A rear cover member 89 is provided at the rear of the shield 2. The cover member 89 is of vacuum formed ABS plastics material with an electrically conductive metallic foil 90 laminated to the inner surface thereof. A housing 91 integrally formed with the member 89 forms a recess 92 to accommodate a filter means 107 for cables 18 connected to the visual display unit 2. The filter means may be any suitable on line filter such as a band pass filter which may be connected in series with the mains cable to prevent or reduce the passage of data signals down the mains cable. Other cables between the visual display unit and other parts of the data processing apparatus may be connected through the filter. Additionally, in this case to further reduce emission from the cables it is envisaged that a plurality of ferrite rings will be provided around the cable over approximately 8 centimetres of the length of the cable. This portion of the cable will be housed in the recess 92. A cable inlet 93 is provided in the housing 91, and the inlet is closed by a flexible sealing means, which in this case, is provided by a brush type seal 94, see Figs. 5, 11 and 12. Four brush seals 95 are used and as can be seen, they are staggered to provide a zig-zag entry path for the cable 108. The brush seals are of metallically coated fibres, in this particular case, polyester fibres which are metallically coated and are electrically connected to the foil 90. An opening 96 (see Figs. 9 and 10) is provided in the cover member 89 to permit access to controls (not shown) of the visual display unit 2. A hingedly mounted flap 97 also of ABS material and hinged by means of a plastic hinge 98 closes the opening 96. A magnetic clip 109 secures the flap closed. Electrically conductive metal foil 99 is also laminated to the flap 97 and electrically conductive sealing means are provided around the periphery of the opening 96 to ensure electrical engagement between the flap 97 and the cover member 89. The sealing means in this case is provided by a seal 100 formed of sponge 101 enclosed in electrically conductive metal foil 102. The foil laminate 90 of the cover member 89 extends through the opening 96 to engage the seals 100 with

0200513

electrically conductive engagement. As can be seen, the opening 16 in the rear wall 14 of the base 8 corresponds with the recess 92 and the opening 96. Screws 103 on the rear wall 14 engage holes 104 in the cover member 89 and nuts (not shown) on the screws 103 secure the cover member 89 to the base 8. Flanges 106 extending from the cover member 89 similarly protect the material of the cover 9 as do the flanges 88 on the cover member 82.

In use, the cover 9 is normally stored with the transparent member 44 and the vent member 46 in place. With the cover 9 removed, the visual display unit is mounted on the base 8, so that the front of the visual display unit 2 corresponds with the front wall 12. The cover 8 is then lowered over the visual display unit 2 and the base 8 and is secured by means of the hook and eye strips 26, 27, 36 and 37 to the base 8. The rear member 21 of the cover 9 is then secured by means of the hook and eyes strips 26 and 27 and in turn, the rear member 21 is secured to the base 8. The front cover member 82 is secured in place. The cables are entered through the inlet 93 in the rear cover member 89 and the ferrite rings (not shown) are mounted on the cable. The cable is then connected into the filter 107 and the rear cover member 89 is secured. Access to the various controls of the visual display unit 2 is achieved through the flap 97 and the hollow member 59.

While in this particular embodiment of the invention, the screen 49 has been described as being formed from a laminate of an inner and and outer panel of glass sandwiching a grid 56 which is formed by a metal spluttering technique, it is envisaged in certain cases that the grid 56 could be formed by an electrolytic forming process, such as, for example, is used in forming printing screens for rotary drum printers. The grid in this case would be formed by electrolytic deposition of, for example, nickel on a former, and the nickel would be formed with a grid pattern of relatively fine mesh size. The grid would then be placed between the panels of glass 54 and 55.

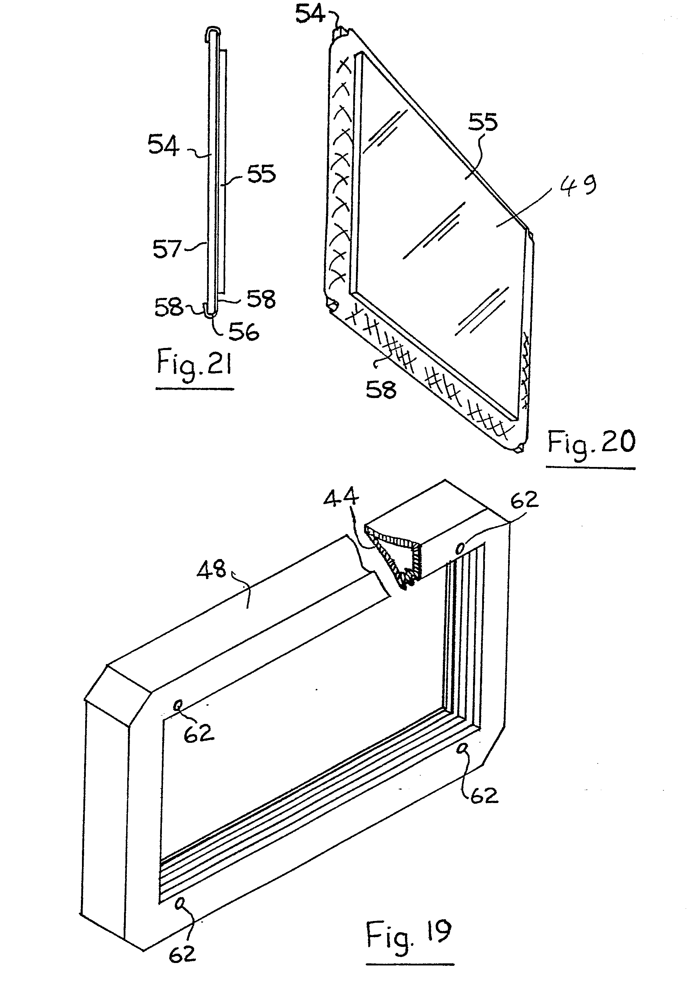

Referring to Figs. 22 to 24 there is illustrated a shield 110 according to another embodiment of the invention, for shielding a keyboard 111 also of electronic data processing apparatus. In this case, the shield 110 comprises a base member 112 of sheet metal and a cover member 113, an intermediate member 114 both of vacuum formed ABS plastics material. The base member 112 comprises a base 115, front, rear and side walls respectively 116, 117 and 118. A flange 123 extends along the front wall 116 for a purpose as will be described below. As can be seen, the walls 116, 117 and 118 are of height which substantially correspond to the shape of keyboard 111. An opening 137 is provided in the rear wall 117 to provide access to controls of the keyboard 111. A flap 138 of ABS material laminated with electrically conductive metallic foil 139 closes the opening 137. The flap 138 is secured by screws (not shown) through holes 140 and 141 in the flap 138 and the wall 117. A magnetic securing fastener 148 secures the flap closed. Electrically conductive sealing means 147 similar to the seal 100 of the rear cover member 89 of the shield 1 extend around the periphery of the opening 137 to seal the flap to the rear wall 117. A corresponding opening 144 is provided in the top member 113 to clear the flap 138.

A cable inlet 145 is also provided in the rear wall 117 of the base member 112. Brush seals 146 similar to the brush seals 93 of the cable inlet 92 of the shield 1 close the inlet 145.

The cover member 113 substantially corresponds with the base member 112 having a top 119, front, rear and side walls respectively 120, 121 and 122, which embrace the front, rear and side walls of the base 112. An opening 124 is provided in the top 119 to provide access to the controls and keys on the keyboard 111.

The intermediate member 114 is bent at 125 to accommodate the contour of the side walls 118 of the base 112. Openings 126 are provided in the intermediate member 114 to provide access to the keys and controls of the keyboard. An electrically conductive sealing means, in this case, provided by deformable seals 127 similar to the seals 100 of the rear cover member 89 of the shield 1, extend around the periphery of the intermediate member 114 on both sides thereof. Thus, when the cover and base members are assembled together, the intermediate member and its seals 127 are sandwiched between the top 119 of the cover member 113 and the front, rear and side walls 116, 117 and 118 of the base member 112. An electrically conductive metal foil laminate 134 is provided on the inner surface of the top member 113, and electrical conductive metal foil 135 is laminated onto the underside of the intermediate member 114. The foil n the underside of the intermediate member 114 is lapped around to engage the seal 127 on the top side, thus when the shield 110 is assembled, electrical continuity is maintained between the three members 112, 113 and 114. This provides complete electric continuity between the cover, base and intermediate members 112, 113 and 114. Screws (not shown) are provided through holes 129 and 130 in the cover and base members for securing the two together.

In use, the keyboard is mounted in the base member 112. The intermediate member 114 is overlaid on the keyboard 111, so that the seals 127 sit on the top of the front, rear and side walls 116, 117 and 118. The cover member 113 is then placed over the intermediate member, so that it embraces the intermediate and base member. Screws (not shown) through the holes 129 and 130 secure the cover, base and intermediate member together.

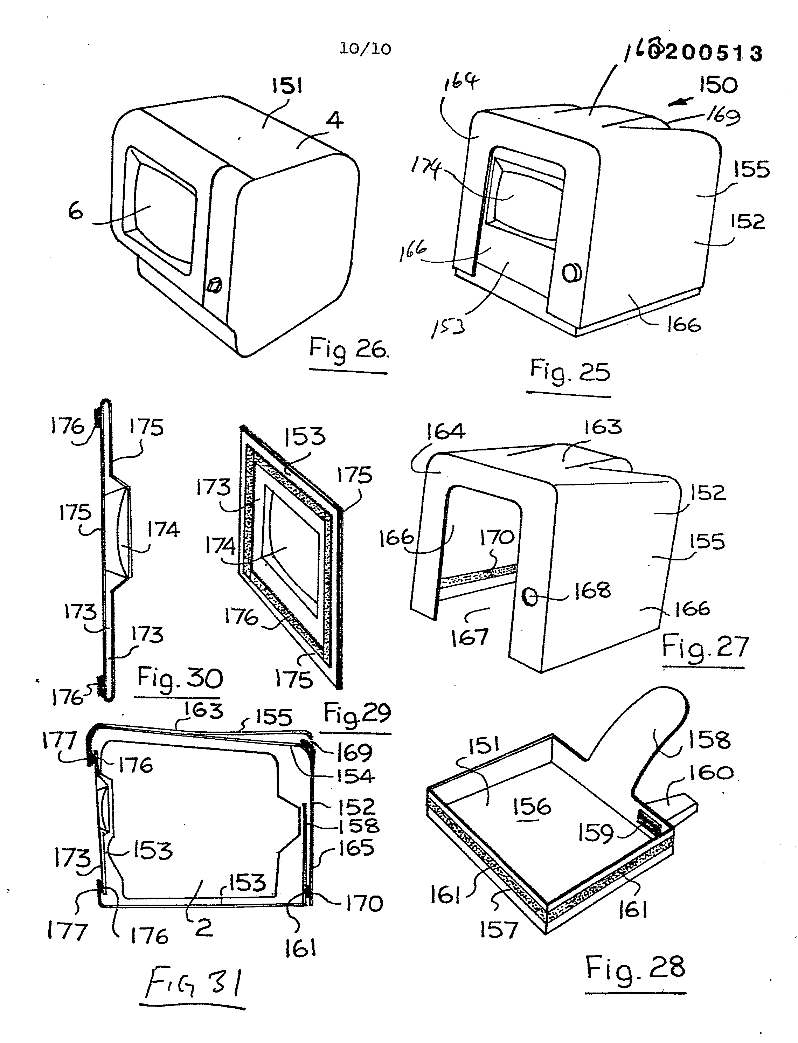

Referring now to Figs. 25 to 31 there is illustrated a shield according to another embodiment of the invention indicated generally by the reference numeral 150 which in this case is also for shielding a visual display unit 151 for use in electronic data processing equipment. The visual display unit 151 is substantially similar to that already described with the exception that it is not mounted on a plinth, otherwise similar parts are identified by the same reference numerals. In this case the shield 150 is constructed in three parts, namely a base 151, a cover 152 and a front screen 153. The base 151 and the cover 152 are of flexible material, in this case formed by two layers, namely an inner layer 154 and an outer layer 155 of metallically coated fabric. The outer layer 155 is a woven multifilament polyester material similar to the material of the shield 1, namely a material coated with nickel and having a nominal DC resistivity of 0.12 ohms/sq cm, screening attenuations for far field conditions of 60 dB at 10 MHz and 60 dB at 26 GHz, and a tolerance power density at 12 GHz of 10 minutes continuous exposure of 3 $W/cm^2$. The inner ply 154 is a transparent woven monofilm and polyester mesh coated with nickel and having a mesh size of 40 microns, a dc resistivity of 0.07 ohms/sq cm screening attenuations for far field conditions of 60 dB at 10 MHz and 70 db at 26 GHz, and a tolerated power density of 12 GHz with 10 minutes continuous exposure of 30 $W/cm^2$.

The base 151 is cut from two single sheets of the inner and outer layers 154 and 155 and formed by stitching, it comprises a base portion 156 with side walls 157. A tongue 158 which will be described below, extends up from the rear side wall 157. A cable inlet 159 is provided in the rear side wall 157 for cable access and a sleeve 160 extends from the inlet 159 to shield portion of the cable. Strips 161 of metallised hooks and eyes fastening members are stitched around the outer surfaces of the side walls 157 to engage the cover 152 as will be described below.

The cover 152 is stitched together from two single sheets of material forming the inner layer 154 and the outer layer 155. The cover comprises a top member 163, a front member 164, a rear member 165 and a pair of side members 166. An opening 167 is formed in the front member 164 to accommodate the screen member 153. An opening 168 to accommodate a control knob of the visual display unit 2 is also provided in the front member 64. A vent 169 is provided in the top member 163 adjacent the rear wall 165 to permit air circulation through the visual display unit. As can be seen particularly clearly in Fig. 31 the vent opening 169 is only formed in the outer layer 155. The inner layer 154 is continuous, since it is sufficiently porous to permit air to pass therethrough.

Strips 170 of metalised hooks and eyes corresponding to the strips 161 are provided around the lower portion of the inner surfaces of the front, rear and side walls of the cover 152 to engage the base 151.

The screen member 153 comprises a frame 173 of vacuum formed ABS material and a translucent member 174 similar to the screen 49 of the shield 1. In this case, the outer and inner surfaces of the frame 173 are laminated with electrically conductive metal foil 175. Strips 176 of metalised hooks and loop material extend around the outer surface of the frame 173 to engage corresponding strips 177 on the inner surface of the cover 152 and on the inner surface of the front side wall 157 of the base member 151, thereby securing the screen member to the cover and base member. By virtue of the fact that the metallically coated hooks and loops fastening means are used, electrical continuity is maintained between the cover base and screen members.

The tongue 158 as can be seen in Fig. 31 extends upwardly of the base behind the rear of the cathode ray tube of the visual display unit to give further radiation shielding.

If desired, a reinforcing framework may be stitched into the cover member 152. Additionally, if desired, the inner layer of material 154 of the cover may extend downwardly to pass behind the screen member 153 in front of the screen 6 of the visual display unit 2 to further increase the shielding properties of the shield.

In use, the visual display unit is mounted on the base 151, the screen member 153 is then mounted in front of the screen of the visual display unit and secured to the base 151. The cover is mounted over the screen member 153 and the base member 151 and secured.

While the shield according to the invention has many advantages, for example, it provides a relatively lightweight shield which does not interfere with the ability of the apparatus being shielded being readily easily moved, and it also has the advantage that it is relatively easily mountable on and removable from the apparatus being shielded, while at the same time having the major advantage that in many cases it prevents and in virtually all cases it reduces the radio wave emission to a level where it is not possible to remotely pick it up and reproduce it, it has the great advantage that it also, in reducing and in many cases preventing the emission of radio waves, it reduces and in many cases eliminates the health hazards associated with using electronic apparatus which emit such waves, be they radio waves, high frequency waves, very high frequency waves, ultra high frequency waves, micro waves or the like. It has long been known that exposure to such waves does present health risks, and in particular, it has been known that pregnant women are particularly at risk, in that such waves may damage the foetus. Thus, the shield according to the present invention, as well as securing the confidentiality of the information being displayed or processed in the apparatus being shielded, also reduces and eliminates the health risk associated with operating such apparatus.

A further advantage of the invention is that by virtue of the construction and materials from which the shield is manufactured, a relatively inexpensive shield is provided.

Another advantage of the invention is that as well as reducing or blocking out the electronic sector of the signals, it also reduces or blocks out the magnetic sector.

It will be appreciated that while in this particular case three constructions of shields have been described shields of any other shape or construction could be used without departing from the scope of the invention. It is envisaged that different shapes and constructions will be required for different makes and models of visual display units, keyboards and the like. Indeed, it will, of course, be appreciated that while the shield has been described for use with a visual display unit and a keyboard it could be constructed for any other portion of the apparatus of electronic data handling equipment. Indeed, it will be appreciated that it may be used for other electronic apparatus besides electronic data handling apparatus, for example, a microwave oven or the like.

It will also, of course, be appreciated that while in one case a single layer of textile material has been described and in another case a double layer has been described, any number of layers may be used, and the layers of material may be similar to each other or each may have different shielding properties. It is also envisaged that other flexible materials besides textile material could be used. In fact, it is envisaged in certain cases that flexible sheet material rather than sheet material manufactured from woven fibres may also be used.

While particular venting arrangements have been described, any other suitable venting arrangements could be used. Although, needless to say, while not being absolutely essential, it is preferable that some form of attenuation means is built in to the venting arrangement. In fact, in certain cases, the vents could be dispensed with altogether. Similarly, it will be appreciated that while a particular closure arrangement has been provided over the cable inlets by way of brush seals, although preferable, this is not necessary. Needless to say, where a closure member is desired, other suitable closure arrangements could be provided.

It is also envisaged that while the apparatus has been described in all cases having a cover member and a base, other suitable constructions could be used, for example in certain cases it is envisaged that the front, side and rear walls could be formed integral with the base. Indeed, in certain cases, it is envisaged that the entire shield could be formed in one piece, having some form of flap covering an opening which would facilitate placing of the visual display unit within the shield.

It is also envisaged that, in certain cases, the shield would be constructed entirely from a flexible material without any rigid or semi-rigid material being provided.

It is further envisaged that in certain cases the screen portion or translucent member could be dispensed with and an opening would merely be provided in the screen. Although, needless to say, this would permit some radiation emission from the cathode ray tube, it is felt that it is a feasible alternative.

Furthermore, it is envisaged that while hooks and loop fastening means have been described for fastening the components of the shield together, any other suitable fastening means could be used, for example, stud fasteners, zips, buttons, or any other suitable fastening means.

It will of course be appreciated that while the shield of the embodiment of the invention described with reference to Figs. 1 to 21 has been described as incorporating a fan, this is not necessary, in certain cases it is envisaged that the fan may be dispensed with.

Needless to say, where a translucent member is provided for the screen, any other suitable translucent member besides laminated glass with a nickel or silver laminate could be used. In fact, in certain cases it is envisaged that a woven textile material could be used with an adequate mesh size. Other suitable translucent materials, it is envisaged could include a transparent plastics material laminated with either a metallically coated textile material or a metallic mesh, either formed from woven fibres or electrolytic deposition. Alternatively, a metal oxide could be applied to the glass.

It is also envisaged that while the keyboard shield has been described as being constructed of rigid material, this could, if desired, be constructed from flexible material, such as for example, the material used in either of the shields for the visual display unit. In fact, it is envisaged that where a flexible material is used, the flexible material could extend entirely over the keyboard and control panel as one could actually access and operate the keys and controls through the material. Needless to say, in certain cases, it is envisaged that a plurality of X shaped slits could be cut in the flexible material corresponding with the position of each key and each control to permit more easy access. It will of course be appreciated that while the keyboard is provided as a substantially rigid shield, a portion of flexible material could be provided across the keyboard.

While the shield for the visual display unit of Figs. 1 to 21 has been described as comprising a housing to accommodate a filter for the cable, this is not necessary, the filter could be dispensed with if desired, and accordingly, the corresponding portion of the housing could also be dispensed with.

Similarly, flaps and the like to close access openings could be dispensed with and indeed in certain cases the access openings to various controls could be dispensed with altogether.

Additionally, it will be appreciated that while the rigid portions of the shield have been described as being either of sheet metal or ABS plastics material, they could be of any other suitable material. Indeed, they could be of ABS material, formed by a process other than vacuum forming. The important thing, however, is that where they are of a plastics material, it is preferable that they should be coated with an electrically conductive coating. While in the embodiments of the invention described, metal foil has been described as being laminated on to the ABS plastics material to provide the electrically conductive coating, any other suitable coating could be used, for example, in certain cases a metallic paint may be sprayed, painted or spluttered onto the plastics material. Needless to say, other electrically conductive layers will be readily apparent to those skilled in the art.

It will also, of course, be appreciated that while the shield has been described as extending completely around the visual display unit and indeed the keyboard, this is not absolutely necessary, for example in certain cases, it is envisaged that the shield may only extend partly around the apparatus to be shielded, for example, it is quite likely that a shield could be provided for a visual display unit substantially similar to the cover portion of the shield described with reference to Figs. 1 to 21 and the base could be dispensed with altogether. While this would permit some emission of radio waves from the apparatus, in certain cases, it is felt that the level of emission may be acceptable. In certain other cases, it is envisaged that portions of the front, the rear, the side or top portions could be dispensed with, without departing from the scope of the invention.

It is also envisaged in certain cases that some or all of the material of the shield could be provided from a piezo electric material, such as for example, a piezo electric plastics membrane. In which case, it is envisaged that movement of the shielding material would generate radio wave signals and these would interfere with any slight radio wave emissions from the apparatus. For example. in the case of a keyboard shield, a covering of piezo electric membrane may be provided across the keyboard, so that as the operator keys into the machine, the keying action on the piezo-electric membrane would generate an EMF which in turn would turn would transmit radio wave signals.

It will also of course be appreciated that while the apparatus has been described for shielding radio wave signals, it could also be used for shielding any other signals, such as very high frequency signals, ultra high frequency signals, micro wave signals and the like.

It will of course be appreciated that while the flexible material has been described as being nickel coated polyester, any other suitable textile material either synthetic or natural could be used. Needless to say, other electrically conductive materials could also be used, for example, silver, gold, aluminium, platinium or the like. Additionally, it will be appreciated that

0200513

the textile material may be coated when woven or knitted as the case may be, or alternatively, the fibres or strands of the material could be coated prior to weaving or knitting. Indeed, where polyester material is used, other grades of the material could be used without departing from the scope of the invention.

It is also envisaged that a sleeve of the flexible material of the cover may be provided to shield the cables. It is envisaged that such a sleeve would extend over most if not all of the length of the cables.

CLAIMS

1.  A shield (1) for electronic apparatus (2) to prevent, reduce or distort the emission of radiated signals, for example, radio waves, ultra high frequency waves, very high frequency waves, micro waves, low frequency waves, or the like, the shield (1) being of the type which in use is adapted to extend at least partly around the apparatus (2) characterised in that the shield (1) is removably mountable on the apparatus (2) and being of a material (8,9) which prevents, reduces or distorts the signals.

2.  A shield as claimed in claim 1 characterised in that at least portion of the shield (1) is of a flexible material (19,20,21,22).

3.  A shield as claimed in claim 2 characterised in that the flexible material is a metallised textile material (19,20,21,22).

4.  A shield as claimed in any preceding claim characterised in that the shield (1) extends completely around the apparatus (2), an opening (30) being provided for entry of the apparatus (2) into the shield, and a closure member (8) closing the opening (30), the closure member (30) being secured to the shield (1) by quick release fastening means (36,37), the closure member (8) being in electrical conductive engagement with the shield around the periphery of the opening.

5. A shield as claimed in claim 4 characterised in that the shield (1) comprises a top cover (9) of flexible material having a top member (19), front (20), rear (21) and side (22) members extending from the top member (19), the opening (30) being defined by the lower portion (29) of the front (20), rear (21) and side (22) members, and the closure member (8) being provided by a base member (8) of a rigid material and electrically conductive portion (33) of the cover (9) adjacent the opening overlaps portion of the base (8).

6. A shield as claimed in any preceding claim characterised in that at least portion (44) of the shield (1) is of a transparent or translucent material (49) to provide visual contact with the apparatus (2).

7. A shield as claimed in claim 6 characterised in that the transparent or translucent material (49) is formed by a panel of glass (54,55) laminated with a grid (56) of electrically conductive material, the laminated panel being mounted in a frame (48) of electrically conductive material (50) secured to and in electrically conductive engagement with the shield (1).

8. A shield as claimed in any preceding claim characterised in that an inlet (15,75) and outlet (76) vent are provided for the circulation of air through the shield (1), the vents (15,75,76) being provided by a plurality of elongated holes (81), a fan (80) being provided to circulate air through the shield (1).

9. A shield as claimed in any preceding claim characterised in that a cable inlet (93) is provided in the shield (1), the inlet (93) being closed by a flexible seal (95) provided by a brush member (95) comprising a plurality of metal coated fibres extending across the cable inlet (93).

10. A shield as claimed in claim 4 characterised in that the quick release fastening means (36,37) is provided by metal coated hook and loop fasteners (36,37).

11. A shield as claimed in claim 2 characterised in that the flexible material (19,20,21,22) is a nickel coated woven polyester fabric.

12. A shield (1) for an electronic apparatus (2) to prevent, reduce or distort the emission of radiated electro-magnetic signals comprising a housing (8,9) defining an interior region for receiving the apparatus (2), and means for suppressing electro-magnetic signals radiated by the apparatus with said means including a flexible, electrically conductive material integrally formed with said housing.

Fig. 1

Fig. 2

Fig. 3

Fig. 24

0200513

Fig. 4.

Fig.5

Fig.11

Fig.12

Fig.15

Fig.6

Fig.10

Fig.9

0200513

Fig. 7.

Fig. 18

Fig. 8

Fig. 13

Fig. 14

Fig. 17

Fig. 16

Fig. 23

Fig. 22.

Fig.21

Fig. 20

Fig. 19

Fig 26.

Fig. 25

Fig. 30

Fig. 27

Fig.29

Fig. 28

FiG 31

European Patent
Office

**EUROPEAN SEARCH REPORT**

0200513

Application number

EP 86 30 3190

## DOCUMENTS CONSIDERED TO BE RELEVANT

| Category | Citation of document with indication, where appropriate, of relevant passages | Relevant to claim | CLASSIFICATION OF THE APPLICATION (Int Cl.4) |
|---|---|---|---|
| P,Y | US-A-4 381 421 (W.D. COATS et al.) <br> * Column 1, line 65 - column 2, line 58 * | 1,6,7 | H 05 K 9/00 |
| P,Y | US-A-4 514 585 (R.D. PAYNTON) <br> * Column 2, lines 23-52 * | 1,6,7 | |
| Y | DE-A-3 430 406 (RIKEN EMC) <br> * Page 4, last line - page 5, paragraph 2 * | 1,6,7 | |
| A | GB-A-2 052 892 (INTERNATIONAL COMPUTERS LTD.) <br> * Whole document * | 9 | |
| A | EP-A-0 042 369 (SIEMENS AG) <br> * Whole document * | 8 | TECHNICAL FIELDS SEARCHED (Int. Cl.4) <br><br> H 05 K <br> H 01 J |
| A | US-A-4 201 825 (H. EBNETH) <br> * Column 1, line 39 - column 2, line 20; column 2, lines 57-69; column 3, lines 30-49 * | 2,3,11 | |
| A | US-A-3 432 609 (W.C. DUVALL et al.) <br> * Claim 1 * | 1-3,10 -12 | |

The present search report has been drawn up for all claims

| Place of search | Date of completion of the search | Examiner |
|---|---|---|
| THE HAGUE | 25-07-1986 | SCHRIJVERS H.J. |